# EUROPEAN PATENT SPECIFICATION

(11) **EP 2 122 676 B1**
(45) Date of publication and mention of the grant of the patent: **27.02.2013**
(21) Application number: 07860920.3
(22) Date of filing: 19.12.2007
(51) Int. Cl.: H01L 21/677, H01L 21/683, B65G 49/06, B28D 5/00

(54) **METHOD AND DEVICE FOR SEPARATION OF SILICON WAFERS**
VERFAHREN UND EINRICHTUNG ZUR TRENNUNG VON SILIZIUMWAFERN
PROCÉDÉ ET DISPOSITIF DE SÉPARATION DE TRANCHES DE SILICIUM

(30) Priority: 19.12.2006 US 875541 P
(43) Date of publication of application: 25.11.2009
(73) Proprietor: REC Wafer Pte. Ltd., Singapore 637312 (SG)
(72) Inventor: WANG, Per Arne, 3919 Porsgrunn (NO); RAMSLAND, Arne, 3530 Røyse (NO); TRONRUD, Ole Christian, 3534 Sokna (NO); HJERTAAS, Erik, 3410 Sylling (NO); HAMMEL, Bent, 0274 Oslo (NO); SKEIE, André, 3512 Hønefoss (NO); TRONRUD, Ola, 3530 Røyse (NO)
(74) Representative: Onsagers AS
(86) International application number: PCT/NO2007/000453
(87) International publication number: WO 2008/075970

(56) References cited:
- EP-A1- 1 935 599
- WO-A-01/28745
- WO-A-2004/051735
- DE-A1- 19 900 671

## Description

### Technical field

The present invention relates to a method and a device for separation of silicon wafers from a horizontal stack of silicon wafers. In the present application the term horizontal refers to a stack where the stacking direction for the wafers is horizontal, i.e. the surface of the wafers is located in a substantially vertical plane.

### Prior art

In the production of silicon wafers for use in solar cells, silicon ingots are cut up into thin wafers. As a rule the ingots are sawed up into wafers in a parallel manner and in a liquid-cooled sawing process, and as a result of this and subsequent processes the product consists of a stack of moist, thin silicon wafers. In the subsequent process each individual wafer is to be treated individually.

The separation of each individual wafer from the stack is currently conducted as a manual operation, where an operator lifts/pulls the outermost wafers from the stack and places them in a cassette or in turn on an assembly line for transport to the next processing stage.

This process is not without its problems. The wafers are held together by a force which is determined by cohesive, adhesive and viscous properties in the medium between the wafers as well as the roughness in the surface of the wafers. Furthermore, the separation is a work-intensive operation, and at the same time there are limits to the speed at which it can be performed. The manual operation results in a large proportion of the wafers being damaged during the operation. In the solar cell industry there is a need to reduce the thickness of the wafers, 100µm - 200µm, with the result that the requirement for extremely careful handling becomes even more important.

In the publication WO 2004/051735 a device is disclosed for separation of silicon wafers from vertical stacks. The wafers are lying in a horizontal plane and are moved in this plane. A transport device is employed here which lifts the top silicon wafer in a vertical stack away from the stack while a fluid is blown in between the top silicon wafer and the second top silicon wafer in order to help them to be separated from each other. A disadvantage of this technique is that there is still a great risk of damage during the separation of the silicon wafers. The transport device comprises means for attachment to the wafer, which means exert pressure on single points in the wafer. Together with the fluid blown from the sides, this pressure is intended to surmount the capillary forces between the wafers. The pressure may therefore cause deformation of the wafer and at worst cause it to break. The publication shows how this problem is solved by the transport device also including parts which hold the wafer back and avoid folding thereof.

DE 102005016518 discloses an apparatus for detaching wafers from a carrier system and for singularization of a horizontal stack. As described herein, the carrier system is a sheet (usually of glass) which is used to secure the silicon (with glue) during the sawing process. This glass sheet and the glue have to be removed afterwards in order to perform the singularization. The publication describes a chisel used to strike into the glass sheet under the outermost wafer, causing it to loosen, together with glue and glass remnants. What can happen, however, is that it immediately sticks to the adjacent wafer, resulting in failure to achieve singularization.

The above publications refer to handling of wafers for the electronics industry. These wafers have better mechanical characteristics and can withstand relatively great mechanical loading, due amongst other things to the fact that they are relatively thick (300-400 µm). Solar cell wafers on the other hand are extremely fragile and weak and require gentler treatment. The present invention is intended amongst other things to be capable of performing singularization for these wafers. The invention, however, can also be employed for singularization of wafers with thicknesses different to those of the solar cell wafers (e.g. 200-400 µm).

WO01/28745 describes a method and an apparatus for isolating plate-like substrates comprising vacuum gripping means and the utilization of oscillating movement in different directions to isolate a substrate from a stack.

DE19900571 A1 discloses an apparatus and a method for releasing wafers from a stack. Wherein the separation of the wafers is supported by a fluid stream between neighbouring wafers.

EP1935599A1 disclose an apparatus and a method for separation and transportation comprising a carrying device arranged within a fluid in which a substrate stack is arranged, an unloading device comprising a gripper with means for taking up and moving away a substrate, a flow device for fanning a part of the stack and a pressing element.

The object of the present invention is to provide a method and device for improving separation of silicon wafers, i.e. for separating the silicon wafers more efficiently, and where the proportion of damaged silicon wafers is reduced or nullified.

### Summary of the invention

The invention comprises a method for separation of a silicon wafer from a horizontal stack of silicon wafers according to claim 1. The method is characterised in that it comprises the following steps: a) attaching a movable transport device to a surface in the outermost silicon wafer in the stack and b) moving the silicon wafer in a substantially vertical plane until the silicon wafer is separated from the stack.

The silicon wafers separated by means of the method and the device according to the invention are, for example, wafers for production of solar cells. Such wafers are thin (100µm-200µm), and the handling thereof is particularly critical.

The term "stack" refers to the product obtained after sawing and dissolution of the adhesive layer, or after removal of the adhesive layer in another way. The forces holding the wafers together in a stack are a combination of adhesive, cohesive, viscous and mechanical forces (the adhesive and cohesive forces constitute the so-called capillary forces).

In the illustrated embodiments of the invention the movement of the wafer in the vertical plane will take place substantially upwards, i.e. in the direction opposite to the force of gravity, thereby achieving a controlled movement of the wafers.

Several directions can be defined in the vertical plane, thereby making it possible to define several variants of the invention, where, for example, the wafer is moved in a horizontal, vertical or curved path in the vertical plane.

The expression "in a substantially vertical plane" refers to a movement which does not include tilting movements (such as those which occur when a wafer which is still attached to an ingot at one end is separated therefrom). Tilting movements will cause internal mechanical stresses in the wafers which may lead to their destruction. The invention provides a vertical movement of the wafer until it is separated from the stack, i.e. until the wafers' surfaces are no longer located opposite one another.

Thus the method according to the invention may, for example, comprise as a part of step b) movement upwards substantially along a vertical (this embodiment will be illustrated in the drawings), a horizontal, a slanting or a curved path. The last-mentioned embodiment will be illustrated in the drawings. In a variant of the method the curved path is provided by means of a wheel to which the wafers are attached with the result that the movement is performed along a curved part of a circular path. With large wheels the path of movement will approach the horizontal.

The method according to the invention is conducted completely or partly submerged in a liquid-filled vessel.

In an embodiment the method comprises spraying a liquid or fluid on to the silicon wafer. This step has several variants with different functions. In one variant liquid is sprayed in a vertical downwardly directed jet. The object of this is to hold back the wafer second from the front while the front wafer is moved away from the stack. In another variant liquid spraying is used to separate the front wafers so that they remain located in a stable position with a spacing of between 200 and 2000 micrometers. This last variant helps to make the separation less sensitive to thickness variations in the wafer. Providing spacing between the front wafers, moreover, permits water to flow over the whole wafer surface and the surface of the wafers is cleaned by water and/or chemicals suited to the purpose. Another function of liquid spraying is to remove any gas bubbles in the water, thereby reducing the capillary forces between the wafers. In this case the spacing between the wafers will be so great that viscous counterforces can be ignored.

In another embodiment the method comprises prevention of simultaneous movement of the remaining silicon wafer or wafers in the stack by means of a blocking device.

In an embodiment the method comprises the following step after step b): c1) removing the wafers from the transport device. This may be carried out by means of a movement of the wafer or the transport device along a direction perpendicular to the wafer's (and the transport device's) plane, for example by means of air which is blown from the transport device on to the wafer or by means of a fluid passed from the transport device to the wafer. The removal may also be implemented by a relative movement between the transport device and the wafer along the plane of the wafer, or by a combination thereof.

In another embodiment the method comprises the following steps after step b): c2) moving the stack towards the transport device a distance corresponding to the thickness of the silicon wafer and d) repetition of steps a) - b) for separation of the next silicon wafer from the stack.

Steps c1) and c2) may be conducted simultaneously or in succession, where it is possible to begin with c1) or with c2).

The liquid may, for example, be water, deionised water or water with additives for reducing the viscosity and/or surface tensions in order to facilitate the separation of the silicon wafer from the stack. The liquid has a temperature of between 10-70°C, preferably 30-60°C and even more preferred 50°C. There are a great many substances on the market for reducing the capillary forces and the viscosity in the water. Heated water reduces both the surface tensions and the viscosity.

The invention also comprises a device for separation of a silicon wafer from a horizontal stack of silicon wafers according to claim 9. The device is characterised in that it comprises a movable transport device for attaching to a surface of the outermost silicon wafer in the stack, where the movable transport device is arranged for movement of the silicon wafer in a substantially vertical plane until the silicon wafer is separated from the stack. The device comprises a liquid-filled vessel wherein the stack is completely or partly submerged.

In an embodiment the device comprises an apparatus for moving the outermost wafer substantially along a vertical, horizontal, slanting or curved path in the vertical plane. An example of the last-mentioned alternative comprises a wheel to which the outermost wafer is attached.

In an embodiment the device comprises one or more nozzles for spraying a liquid or fluid on to the silicon wafer in order to counteract the binding forces between the silicon wafer attached to the transport device and the adjacent silicon wafer.

In another embodiment the device comprises a blocking device for preventing simultaneous movement of the underlying silicon wafer or wafers in the stack.

In another embodiment the device comprises means for removing the wafers from the transport device.

In another embodiment the device comprises means for moving the stack towards the transport device a distance corresponding to the thickness of the silicon wafer, thereby permitting separation of the next silicon wafer from the stack by means of the transport device.

Even though individual features of the invention have been described in connection with different embodiments and variants thereof, it will be obvious to a person skilled in the art that combinations thereof also fall within the scope of the patent claims.

### Detailed description

The present invention will now be described in detail with reference to the attached drawing which schematically illustrates an embodiment of the invention.
Figure 1 is a view of a first embodiment of the invention.
Figure 2 is a view from in front of a second embodiment of the invention.
Figure 3 is a detail of the wheel in the second embodiment of the invention.
Figure 4 is a view from above of the second embodiment of the invention.
Figure 5 is a view from below of a part of the second embodiment.

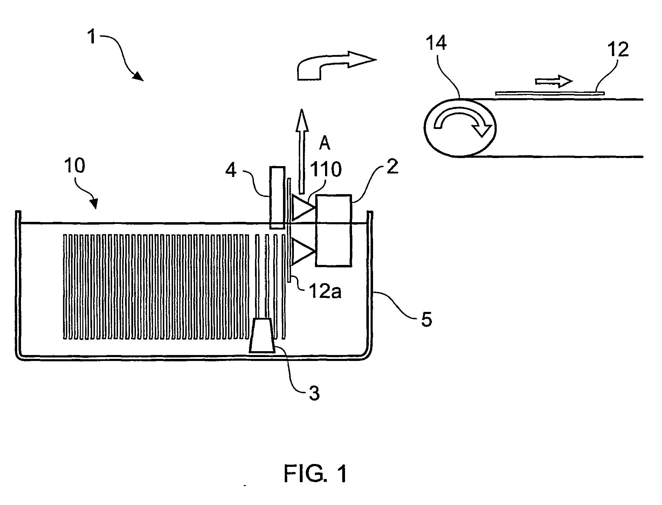

Figure 1 illustrates a device 1 according to the invention for separation of a silicon wafer from a horizontal stack 10 where a plurality of silicon wafers 12 are arranged in a vertical position in a liquid-filled vessel 5. By vertical position we mean that each wafer in the stack is lying vertically, while the actual stack is horizontal.

The device 1 comprises a transport device 2 which in this embodiment of the invention has one or more suction devices 110 capable of adhering to the surface of the outermost silicon wafer 12 together with means (not shown) for moving the transport device 2 horizontally and vertically towards the outermost wafer and subsequently pushing the silicon wafer 12 in a substantially vertical plane and in a vertical direction (arrow A) from the stack 10 to a conveyor belt 14 where the silicon wafer 12 is then deposited and released from the suction devices. The said means (not shown) for moving the transport device 2 comprise a horizontal and vertical servo-controlled pick-up and delivery unit. In an embodiment of the invention the transport device 2 comprises five suction devices 110 placed in the corners and in the middle of the wafer. The horizontal movement comprises moving towards the outermost wafer 12. The vertical movement comprises placing the suction devices 110 opposite the wafer and then moving parallel to the surface of the wafer. Alternatively the stack may be moved horizontally step by step and the suction devices can return to a fixed point.

The suction devices 110 are arranged so as to exert a pushing force on the whole of the wafer's surface, this pushing force being approximately equal for all parts of the wafer. This can be controlled by choosing the correct number and position of the suction devices, which is easily done since the whole of the wafer's surface is available for placing suction devices. The position of the wafer is thereby under control during the entire separation operation by means of the suction devices. In the embodiments of the invention where the stack is submerged in water, a hydraulic (water-based) suction device is employed. In such cases almost no capillary forces are produced, thereby avoiding the use of the blocking device.

The device 1 may further comprise one or more nozzles 3 for spraying a liquid or a fluid on to the stack 10. The liquid is preferably water, or alternatively water with added means for reduction of viscosity and/or surface tensions and thereby the above-mentioned forces binding the silicon wafers 12 together. The water nozzles 3 are designed to give a flat water jet. In other embodiments the nozzles 3 are integrated in a blocking device 4. In an embodiment of the invention the number of nozzles is two, while other embodiments may have up to six nozzles.

In another embodiment the device 1 comprises a blocking device 4, whose function is to prevent simultaneous movement of the adjacent silicon wafer or wafers in the stack. The blocking device 4 is usually a straight plate which may be 2-10mm wide.

Both the nozzles 3 and the blocking device 4 may be movable along the stack 10. The nozzle 3 may also be rotatable, thus permitting the angle of the spraying of liquid on to the stack 10 to vary during the separation process.

The function of the device 1 will now be described in greater detail. The designation 12a is used for the outermost silicon wafer at one end of the stack 10. The silicon wafer 12a is therefore the silicon wafer which has to be separated from the stack 10.

The stack 10 is placed horizontally in the device 1. The stack is preferably submerged in water. After the transport device 2 has been placed in the correct position in front of the wafer 12a, the suction devices 110 are attached to the surface of the silicon wafer 12a.

The transport device attached to the silicon wafer 12a is moved by means of the invention vertically away from the stack 10 and on to a next operation, for example via a conveyor belt 14.

The wafers are delivered to the conveyor belt, for example by increasing the pneumatic or hydraulic pressure in the suction devices.

As already mentioned, the vertical movement results in an extremely careful and controlled handling of the silicon wafer 12a. The risk of destruction of the silicon wafer 12a during this operation is consequently substantially reduced.

In an embodiment of the invention (not shown) the nozzles 3 are omitted. Separation of the wafers in this case is essentially accomplished by the pushing movement.

As mentioned earlier, in some embodiments of the invention a blocking device 4 is provided in the immediate vicinity of the stack 10 during the above moving operation, where the blocking device prevents simultaneous movement of the adjacent silicon wafer or wafers in the stack, thereby ensuring that only silicon wafer 12a is moved during the moving operation.

In order to permit the next silicon wafer in the stack 10 to be separated, either a movement of the stack 10 is undertaken towards the transport device 2, the nozzles 3 and the blocking device 4 by means of the above-mentioned transport device, or alternatively a movement of the transport device 2, the nozzles 3 and the blocking device 4 towards the next silicon wafer. Thereupon the above-mentioned separation process is repeated.

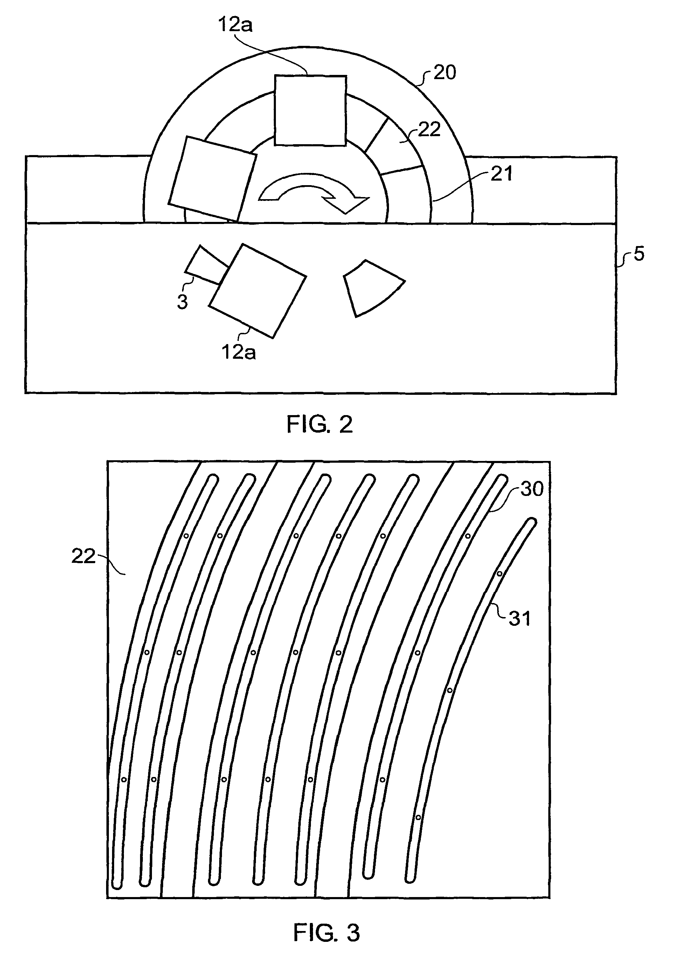

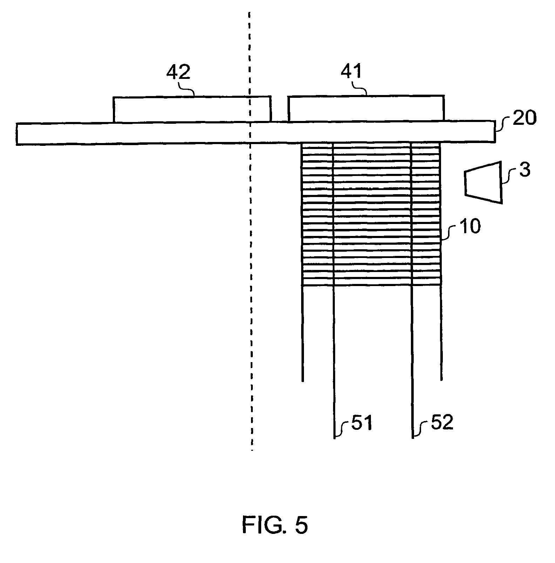

Figure 2 is a view from in front of a second embodiment of the invention. In this version of the invention the transport device is arranged to move the front wafer 12a in the stack 10 in a curved path. The device comprises a wheel 20 made, for example, of aluminium and with areas 22 for temporary attachment of the wafers 12. The wheel 20 also comprises grooves 21 for receiving rods 51 and 52 (see figure 5). The wheel 20 is partly submerged in water in a liquid-filled vessel 5.

Figure 3 illustrates a detail of the attachment areas 22 in the wheel 20 and the grooves where the said rods are to be located. The areas comprise openings 31 and grooves 30 whose purpose is to distribute a suction force on the openings 30. The openings 31 exert a suction force during pick-up of a wafer from the stack and a pushing force during removal of the wafer from the wheel. In this embodiment of the invention the surface of the wheel 20 is substantially flat and smooth, with the result that the capillary forces are sufficient to hold a wafer on the wheel even though the suction force ceases.

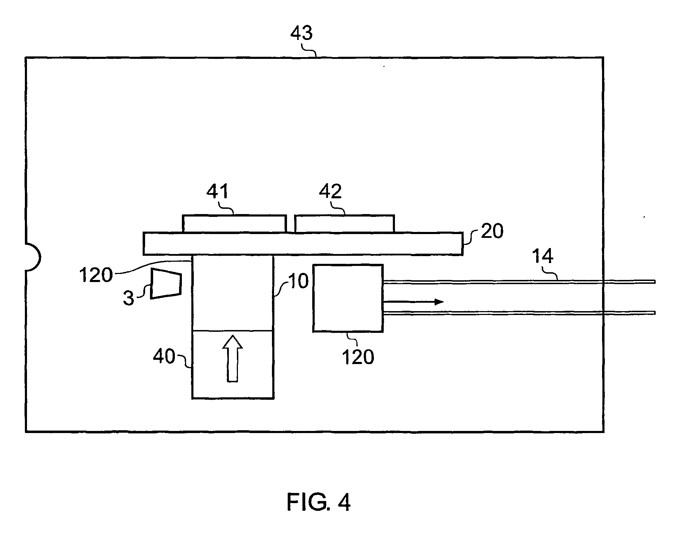

Figure 4 illustrates the second embodiment of the invention viewed from above. In this embodiment it can be seen that the wheel 20 has a substantially vertical position. The device comprises a mechanism 40 for moving the stack 10 towards the wheel 20, thereby ensuring a minimal distance between the front wafer 12a and the wheel 20. The mechanism comprises a container containing two rods 51 and 52 (illustrated in figure 5) for supporting the stack 10. The rods are arranged to be inserted in the grooves without being in physical contact with the wheel. The wafers are thereby held in place from below even when they have come into contact with the wheel 20.

The device further comprises a suction mechanism 41 with a suction manifold located close to the rear of the wheel 20, creating a negative pressure in the water phase and a blowing mechanism 42. In this embodiment of the invention the suction and blowing mechanisms (41 and 42 respectively) have a fixed position and the device comprises coupling devices for connecting the areas 22 in the wheel to the suction and blowing mechanisms at specific locations. These locations are in the area in front of the stack for the suction mechanism and the area in front of the conveyor belt 14 for the blowing mechanism.

During use wheel 20 will rotate in a substantially vertical plane. When an attachment area 22 is located in front of the front wafer in the stack 12a, the said attachment area will be connected to the suction mechanism 41 and a suction force will be exerted. This part of the method takes place under water in the present embodiment of the invention. The capillary forces between the wafers are therefore low and the challenge is to keep control of the wafer's position during the whole separation process. The wafer is located in a container containing the rods 51 and 52, the stack is moved forwards by not shown mechanisms, and the second front wafer is restrained by a blocking device which in this embodiment comprises a nozzle with a downwardly directed (vertical or slanting) water jet.

As mentioned earlier, it will be possible to flush the front wafer with water in order to keep a distance between the wafers and also a vertical position for the wafers.

The outermost wafer 12a in the stack is then pulled towards the wheel 20. The wheel will continue in its rotating motion, while at the same time being transported up from the vessel and away from the suction mechanism 41, and the attachment area will stop exerting the suction force. The wafer 12a will no longer be secured against the wheel 20 by the suction force but by the capillary forces. The capillary forces are strong enough for this task on account of the size of the contact surface. When the attachment area 22 with the wafer 12a attached reaches the area of the belt 14, the blowing mechanism will cause air (or liquid) to be blown out of the openings 31 in order thereby to balance the capillary forces and remove the wafer from the wheel 20. The blow-off may be performed by means of water, air or a combination thereof. Subsequently (or simultaneously) the wafer will be able to be tilted into a horizontal position on the belt 14 or lifted off by a pick-up unit suited to the purpose, for example suction cups, and placed on a belt for further processing.

This ensures that the wafer is treated gently on reception (the blowing forces are slightly greater than the capillary forces and the wafer comes off by itself) or on pull-off of the wafer (the capillary forces are slightly greater than the blowing forces) with one or more suction devices. In the blow-off phase a new pull-off (suction) of the next wafer is carried out under water. A counter (which, e.g., is controlled by a photocell) issues a timing signal for the stack to be moved forward automatically. The stack 10 is pushed forward by a length corresponding to a wafer thickness, or alternatively pushed forward the number of cycles since the last pull-off. The process continues until the stack is empty.

After reception/pull-off in front of the blowing manifold, the wafer is further transported along a conveyor track/belt for further processing.

Even though the figure shows the wheel 20 semi-submerged in water, it is also possible to carry out the process with the wheel completely submerged. In this case the device should be modified so that the wafers are held against the wheel by means of suction until they are pushed off the wheel.

Figure 5 is a view from below of a part of the second embodiment. The figure shows the wheel 20, the suction mechanism 41 and the blowing mechanism 42. The figure also shows rods 51 and 52 which hold the stack 10 from below. The rods 51 and 52 may be connected to a conveyor belt (not shown) which transports the wafers towards the wheel 40.

The invention therefore permits a simple, fast and careful singularization of the wafers. Even though features of the invention have been explained in connection with individual embodiments, it is possible to provide other combinations without departing from the scope of the invention. It is possible, for example, to employ suction manifolds and blowing devices in the embodiment illustrated in figure 1, and it is also possible to employ suction cups in a transport device as illustrated in figure 2 when the latter is not under water.

## Claims

1. A method for separation of a silicon wafer from a horizontal stack of silicon wafers, the method being conducted completely or partly submerged in a liquid-filled vessel (5)
wherein the method comprises the following steps:
a) attaching a movable transport device (2) to a surface of the outermost silicon wafer (12a) in the stack (10),
b) moving the silicon wafer (12a) in a substantially vertical plane until the silicon wafer (12a) is separated from the stack (10)
**characterised in that** the liquid has a temperature of between 10-70°C.

2. A method according to claim 1,
**characterised in that** it comprises movement upwards along a substantially vertical path, a substantially horizontal path, a slanting path or a curved path.

3. A method according to claim 1,
**characterised in that** it comprises spraying a liquid or fluid on to the silicon wafer (12a) in order to separate it, thereby counteracting the binding forces between the silicon wafer (12a) attached to the transport device and the adjacent silicon wafer.

4. A method according to claim 1,
**characterised in that** it comprises prevention of simultaneous movement of the adjacent silicon wafer or wafers in the stack by means of a blocking device (4).

5. A method according to claim 1,
**characterised in that** it has the following step after step b): c1) removing the wafers from the transport device.

6. A method according to claim 1,
**characterised in that** the method comprises the following steps after step b): c2) moving the stack (10) towards the transport device (2) a distance corresponding to the thickness of the silicon wafer (12a); d) repetition of steps a) - b) for separation of the next silicon wafer from the stack.

7. A method according to claim1,
**characterised in that** the liquid is water, or water with additives for reducing the viscosity and/or surface tensions in order to facilitate the separation of the silicon wafer from the stack.

8. A method according to claim 1,
**characterised in that** the liquid has a temperature of between 30-60°C and even more preferred 50°C.

9. A device (1) for separation of a silicon wafer (12a) from a horizontal stack (10) of silicon wafers (12),
wherein the device comprises a movable transport device (2) for attaching to a surface of the outermost silicon wafer (12a) in the stack (10), **characterised in that** the device comprises a liquid-filled vessel (5) in which the stack (10) is completely or partly submerged, where the movable transport device (2) is arranged for movement of the silicon wafer (12a) in a substantially vertical plane until the silicon wafer (12a) is separated from the stack (10) and wherein the liquid has a temperature of between 10-70° C.

10. A device according to claim 9,
**characterised in that** it comprises an apparatus for moving the outermost wafer substantially along a vertical, horizontal, slanting or curved path in the vertical plane.

11. A device according to claim 9,
**characterised in that** it comprises one or more nozzles (3) for spraying a liquid or fluid on to the silicon wafer (12a) in order to separate it, thereby counteracting the binding forces between the silicon wafer (12a) attached to the transport device and the adjacent silicon wafer.

12. A device according to claim 9,
**characterised in that** it comprises a blocking device (4) for preventing simultaneous movement of the underlying silicon wafer or wafers in the stack (10).

13. A device according to claim 9,
**characterised in that** it comprises devices for removing the wafers from the transport device.

14. A device according to claim 9,
**characterised in that** it comprises means for moving the stack (10) towards the transport device (2) a distance corresponding to the thickness of the silicon wafer (12a), thereby permitting separation of the next silicon wafer from the stack by means of the transport device (2).

15. A device according to claim 9,
**characterised in that** the liquid is water, or water with additives for reducing the viscosity and/or surface tensions in order to facilitate the separation of the silicon wafer from the stack.

16. A device according to one of the patent claims 9or 15,
**characterised in that** the liquid has a temperature of 30-60°C and even more preferred 50°C.

## Patentansprüche

1. Verfahren zum Trennen eines Siliziumwafers von einem horizontalen Stapel von Siliziumwafern, wobei das Verfahren vollständig oder teilweise eingetaucht in einem flüssigkeitsgefüllten Behälter durchgeführt wird und folgende Schritte aufweist:
a) Befestigen einer bewegbaren Transporteinrichtung (2) an einer Oberfläche des äußersten Siliziumwafers (12a) in dem Stapel (10),
b) Bewegen des Siliziumwafers (12a) in einer im Wesentlichen vertikalen Ebene bis der Siliziumwafer (12a) von dem Stapel (10) getrennt ist
**dadurch gekennzeichnet, dass**
die Flüssigkeit eine Temperatur zwischen 10 -70 °C aufweist.

2. Verfahren nach Anspruch 1, **dadurch gekennzeichnet, dass** das Verfahren eine Bewegung nach oben entlang eines im Wesentlichen vertikalen Pfades, eines im Wesentlichen horizontalen Pfades, eines geneigten Pfades oder eines gebogenen Pfades aufweist.

3. Verfahren nach Anspruch 1, **dadurch gekennzeichnet, dass** das Verfahren ein Sprühen einer Flüssigkeit oder eines Fluides auf den Siliziumwafer (12a), um diesen zu trennen, umfasst, wobei dabei den Bindungskräften zwischen dem Siliziumwafer (12a), der an der Transporteinrichtung angebracht ist, und dem angrenzenden Siliziumwafer entgegengewirkt wird.

4. Verfahren nach Anspruch 1, **dadurch gekennzeichnet, dass** das Verfahren ein Unterbinden des gleichzeitigen Bewegens des angrenzenden Siliziumwafers oder Wafer innerhalb des Stapels durch eine Arretierungseinrichtung (4) umfasst.

5. Verfahren nach Anspruch 1, **dadurch gekennzeichnet, dass** das Verfahren den folgenden Schritt nach Schritt b) aufweist:
c1) Entfernen der Wafer von der Transporteinrichtung.

6. Verfahren nach Anspruch 1, **dadurch gekennzeichnet, dass** das Verfahren die folgenden Schritte nach Schritt b) aufweist:
c2) Bewegen des Stapel (10) in Richtung der Transporteinrichtung (2) um eine Distanz, die der Dicke des Siliziumwafers (12a) entspricht; d) Wiederholung der Schritte a)-b) zum Trennen des nächsten Siliziumwafers von dem Stapel.

7. Verfahren nach Anspruch 1, **dadurch gekennzeichnet, dass** die Flüssigkeit Wasser, oder Wasser mit Additiven zum Reduzieren der Viskosität und/oder Oberflächenspannungen zum Vereinfachen des Trennens des Siliziumwafers von dem Stapel ist.

8. Verfahren nach Anspruch 1, **dadurch gekennzeichnet, dass** die Flüssigkeit eine Temperatur zwischen 30-60 °C und bevorzugt 50 °C aufweist.

9. Vorrichtung (1) zum Trennen eines Siliziumwafers (12a) von einem horizontalen Stapel (10) von Siliziumwafern (12), wobei die Vorrichtung eine bewegbare Transporteinrichtung (2) zum Befestigen an einer Oberfläche des äußersten Siliziumwafers (12a) in dem Stapel (10) aufweist, **dadurch gekennzeichnet, dass** die Vorrichtung einen flüssigkeitsgefüllten Behälter (5) aufweist, in den der Stapel (10) vollständig oder teilweise eingetaucht ist, wobei die bewegbare Transporteinrichtung (2) eingerichtet ist, den Siliziumwafer (12a) in einer im Wesentlichen vertikalen Ebene, bis der Siliziumwafer (12a) von dem Stapel (10) getrennt ist, zu bewegen und wobei die Flüssigkeit eine Temperatur zwischen 10 -70 °C aufweist.

10. Vorrichtung nach Anspruch 9, **dadurch gekennzeichnet, dass** die Vorrichtung eine Einrichtung zum Bewegen des äußersten Wafers entlang eines im Wesentlichen vertikalen, horizontalen, geneigten oder gekrümmten Pfads in der vertikalen Ebene aufweist.

11. Vorrichtung nach Anspruch 9, **dadurch gekennzeichnet, dass** die Vorrichtung eine oder mehrere Düsen zum Sprühen einer Flüssigkeit oder eines Fluides auf den Siliziumwafer (12a) zum Trennen dessen aufweist, wobei dabei den Bindungskräften zwischen dem Siliziumwafer (12a), der an der Transporteinrichtung befestigt ist, und dem angrenzenden Siliziumwafer entgegengewirkt wird.

12. Vorrichtungsanspruch 9, **dadurch gekennzeichnet, dass** die Vorrichtung eine Arretierungseinrichtung (4) zum Unterbinden eines gleichzeitigen Bewegens des unterliegenden Siliziumwafers oder Wafern innerhalb des Stapels (10) aufweist.

13. Vorrichtungsanspruch 9, **dadurch gekennzeichnet, dass** die Vorrichtung eine Einrichtung zum Entfernen der Wafer von der Transporteinrichtung aufweist.

14. Vorrichtung nach Anspruch 9, **dadurch gekennzeichnet, dass** die Vorrichtung Elemente zum Bewegen des Stapels (10) in Richtung der Transporteinrichtung (2) um eine Distanz, die der Dicke des Siliziumwafers (12a) entspricht, aufweist, wobei dabei ein Trennen des nächsten Siliziumwafers von dem Stapel durch die Transporteinrichtung (2) ermöglicht wird.

15. Vorrichtung nach Anspruch 9, **dadurch gekennzeichnet, dass** die Flüssigkeit Wasser, oder Wasser mit Additiven zum Reduzieren der Viskosität und/oder Oberflächenspannungen zum Vereinfachen des Trennens der Siliziumwafer von dem Stapel ist.

16. Vorrichtung nach Anspruch 9 oder 15, **dadurch gekennzeichnet, dass** die Flüssigkeit eine Temperatur zwischen 30-60° und bevorzugt 50 °C aufweist.

## Revendications

1. Procédé de séparation d'une tranche de silicium d'une pile horizontale de tranches de silicium, le procédé étant effectué complètement ou partiellement immergé dans une cuve (5) remplie d'un liquide,
dans lequel le procédé comprend les étapes suivantes :
a) la fixation d'un dispositif de transport (2) mobile à une surface de la tranche de silicium la plus à l'extérieur (12a) dans la pile (10),
b) le déplacement de la tranche de silicium (12a) dans un plan sensiblement vertical jusqu'à ce que la tranche de silicium (12a) soit séparée de la pile (10),
**caractérisé en ce que** le liquide a une température comprise entre 10 et 70 °C.

2. Procédé selon la revendication 1,
**caractérisé en ce qu'**il comprend un déplacement vers le haut le long d'un trajet sensiblement vertical, d'un trajet sensiblement horizontal, d'un trajet incliné ou d'un trajet incurvé.

3. Procédé selon la revendication 1,
**caractérisé en ce qu'**il comprend la pulvérisation d'un liquide ou d'un fluide sur la tranche de silicium (12a) afin de la séparer, neutralisant de ce fait les forces de liaison entre la tranche de silicium (12a) fixée au dispositif de transport et la tranche de silicium adjacente.

4. Procédé selon la revendication 1,
**caractérisé en ce qu'**il comprend l'empêchement d'un mouvement simultané de la ou des tranches de silicium adjacentes dans la pile au moyen d'un dispositif de blocage (4).

5. Procédé selon la revendication 1,
**caractérisé en ce qu'**il comporte l'étape suivante après l'étape b) : c1) le retrait des tranches du dispositif de transport.

6. Procédé selon la revendication 1,
**caractérisé en ce que** le procédé comprend les étapes suivantes après l'étape b) : c2) le déplacement de la pile (10) vers le dispositif de transport (2) d'une distance correspondant à l'épaisseur de la tranche de silicium (12a) ; d) la répétition des étapes a) et b) pour séparer la tranche de silicium suivante de la pile.

7. Procédé selon la revendication 1,
**caractérisé en ce que** le liquide est de l'eau, ou de l'eau avec des additifs pour réduire la viscosité et/ou les tensions superficielles afin de faciliter la séparation de la tranche de silicium de la pile.

8. Procédé selon la revendication 1,
**caractérisé en ce que** le liquide a une température comprise entre 30 et 60 °C et plus préférablement de 50 °C.

9. Dispositif (1) pour séparer une tranche de silicium (12a) d'une pile (10) horizontale de tranches de silicium (12),
dans lequel le dispositif comprend un dispositif de transport (2) mobile destiné à être fixé à une surface de la tranche de silicium la plus à l'extérieur (12a) dans la pile (10), **caractérisé en ce que** le dispositif comprend une cuve (5) remplie d'un liquide dans lequel la pile (10) est complètement ou partiellement immergée, où le dispositif de transport (2) mobile est agencé pour déplacer la tranche de silicium (12a) dans un plan sensiblement vertical jusqu'à ce que la tranche de silicium (12a) soit séparée de la pile (10), et dans lequel le liquide a une température comprise entre 10 et 70 °C.

10. Dispositif selon la revendication 9,
**caractérisé en ce qu'**il comprend un appareil pour déplacer la tranche la plus à l'extérieur sensiblement le long d'un trajet vertical, horizontal, incliné ou incurvé dans le plan vertical.

11. Dispositif selon la revendication 9,
**caractérisé en ce qu'**il comprend une ou plusieurs buses (3) pour pulvériser un liquide ou un fluide sur la tranche de silicium (12a) afin de la séparer, neutralisant de ce fait les forces de liaison entre la tranche de silicium (12a) fixée au dispositif de transport et la tranche de silicium adjacente.

12. Dispositif selon la revendication 9,
**caractérisé en ce qu'**il comprend un dispositif de blocage (4) pour empêcher un déplacement simultané de la ou des tranches de silicium sous-jacentes dans la pile (10).

13. Dispositif selon la revendication 9,
**caractérisé en ce qu'**il comprend des dispositifs pour retirer les tranches du dispositif de transport.

14. Dispositif selon la revendication 9,
**caractérisé en ce qu'**il comprend des moyens pour déplacer la pile (10) vers le dispositif de transport (2) d'une distance correspondant à l'épaisseur de la tranche de silicium (12a), permettant de ce fait la séparation de la tranche de silicium suivante de la pile au moyen du dispositif de transport (2).

15. Dispositif selon la revendication 9,
**caractérisé en ce que** le liquide est de l'eau, ou de l'eau avec des additifs pour réduire la viscosité et/ou les tensions superficielles afin de faciliter la séparation de la tranche de silicium de la pile.

16. Dispositif selon l'une des revendications 9 et 15,
**caractérisé en ce que** le liquide a une température de 30 à 60 °C et plus préférablement de 50 °C.
